# EUROPÄISCHE PATENTSCHRIFT

(11) **EP 2 959 024 B1**
(45) Veröffentlichungstag und Bekanntmachung des Hinweises auf die Patenterteilung: **23.11.2016**
(21) Anmeldenummer: 14703626.3
(22) Anmeldetag: 23.01.2014
(51) Int. Cl.: C21C 5/56, C21C 5/30

(54) **VERFAHREN UND EINE VORRICHTUNG ZUR KONTINUIERLICHEN ERZEUGUNG EINER FLÜSSIGEN STAHLSCHMELZE AUS SCHROTT**
METHOD AND A DEVICE FOR CONTINUOUSLY PRODUCING MOLTEN STEEL FROM SCRAP METAL
PROCÉDÉ ET DISPOSITIF DE PRODUCTION CONTINUE D'UNE MASSE FONDUE D'ACIER LIQUIDE À PARTIR DE FERRAILLE

(30) Priorität: 19.02.2013 AT 1312013
(43) Veröffentlichungstag der Anmeldung: 30.12.2015
(73) Patentinhaber: Seirlehner, Leopold, 4040 Linz (AT); Tukay, Günther, 6313 Edlibach (CH)
(72) Erfinder: Seirlehner, Leopold, 4040 Linz (AT); Tukay, Günther, 6313 Edlibach (CH)
(74) Vertreter: Keschmann, Marc
(86) Internationale Anmeldenummer: PCT/IB2014/000061
(87) Internationale Veröffentlichungsnummer: WO 2014/128541

(56) Entgegenhaltungen:
- EP-A2- 0 470 067
- GB-A- 2 076 858
- US-A- 4 101 313

## Beschreibung

Die Erfindung betrifft ein Verfahren und eine Vorrichtung zur kontinuierlichen Erzeugung einer flüssigen Stahlschmelze aus Schrott.

Das Einschmelzen von Schrott erfolgt meist in einem Schrottschmelzreaktor. Ein Schrottschmelzreaktor umfasst in der Regel einen von oben beschickbaren, eine Schrottsäule aufnehmenden Schacht, der einen bodenseitigen Schmelzraum mit über den Schachtumfang verteilten, die Umfangswand des Schachtes durchsetzenden Brennern und mit einem Abstich im Bodenbereich bildet. Im Schacht, der von oben mit Schrott und Zuschlagstoffen beschickt wird, ergibt sich eine im Bereich des Schmelzraumes abgestützte Schrottsäule, die über die Brenner von unten aufgeschmolzen wird und im Ausmaß der Aufschmelzung absinkt, wobei die Schmelze und die sich bildende Schlacke abfließen und über einen bodenseitigen Abstich zur Weiterbehandlung abgezogen werden. Durch die aus dem Schmelzraum aufsteigenden Prozessgase wird die Schrottsäule im Gegenstrom erwärmt.

Aus prozesstechnischen Gründen ist es zur Vermeidung von Oxidationsverlusten unerlässlich, dass die im unteren Teil des Schachtes ablaufenden Verbrennungsreaktionen möglichst unterstöchiometrisch ablaufen, weshalb weniger sauerstoffhaltiges Gas in diesem Bereich zugeführt wird, als zur vollständigen Verbrennung mindestens notwendig ist. Die aus der Schmelzzone aufsteigenden heißen Verbrennungsgase enthalten demnach noch brennbare Bestandteile, insbesondere CO, H₂ und CH₄. Zur vollständigen Nutzung der eingebrachten Brennstoffenergie für den Schmelzprozess bzw. die Aufheizung des Einsatzmaterials wird durch Zufuhr von Sekundärluft oberhalb des Schmelzraumes für eine entsprechende Nachverbrennung gesorgt. Diese Nachverbrennung ist insbesondere im Zusammenhang mit Schrott von Bedeutung, der organische Stoffe enthält, wie dies beispielsweise beim Einschmelzen von Schrott aus Kraftfahrzeugen der Fall ist. Durch eine entsprechende Nachverbrennung können nämlich die organischen Schrottbestandteile vorteilhaft als Energieträger für die Schrottvorwärmung genützt und vom metallischen Anteil getrennt werden. Die Abgase aus der Nachverbrennung werden im oberen Schachtbereich über ein Saugzuggebläse aus dem Schacht abgezogen.

Aus der EP 0470067 A2 ist ein Verfahren und eine Vorrichtung zur kontinuierlichen Erzeugung einer flüssigen Stahlschmelze bekannt, umfassend das Einschmelzen von Schrott in einem Schachtofen, das Austragen der erzeugten Stahlschmelze und der anfallenden Schlacke über eine im unteren Teil des Schachtofens angeordnete Austragsöffnung und das Einbringen der ausgetragenen Stahlschmelze und der Schlacke in einen weiteren Ofen und die Behandlung der Schmelze im Durchlaufofen und das Austragen der Stahlschmelze und der Schlacke aus dem weiteren Ofen, wobei Ofengas aus dem Durchlaufofen abgezogen wird und das Ofengas als Brenngas für einen Brenner des Schachtofens verwendet wird.

Nachteilig bei den bekannten Einschmelzverfahren ist der hohe Bedarf an fossilen Energieträgern.

Die vorliegende Erfindung zielt daher darauf ab, den Bedarf an Energieträgern zu reduzieren bzw. die Energieausnutzung zu optimieren.

Zur Lösung dieser Aufgabe sieht die Erfindung ein Verfahren der eingangs genannten Art vor, das folgende Schritte umfasst:
- kontinuierliches Einschmelzen von Schrott gemeinsam mit einem Kohlenstoffträger, wie z.B. Koks, in einem Schachtofen,
- Austragen der erzeugten Stahlschmelze und der anfallenden Schlacke über eine im unteren Teil des Schachtofens angeordnete Austragsöffnung,
- kontinuierliches Einbringen der ausgetragenen Stahlschmelze und der Schlacke in einen Durchlaufofen,
- kontinuierliches Überhitzen und Raffinieren der Schmelze im Durchlaufofen,
- voneinander gesondertes kontinuierliches Austragen der Stahlschmelze und der Schlacke aus dem Durchlaufofen,
- Abziehen von Ofengas aus dem Durchlaufofen,
- zumindest teilweise Entstaubung des Ofengases,
- Leitung des zumindest teilweise entstaubten Ofengases zur energetischen Nutzung seiner fühlbaren Wärme durch einen Abhitzekessel,
- Verwenden des Ofengases als Brenngas für einen Brenner des Schachtofens.

Zur Lösung der Aufgabe sieht die Erfindung weiters eine Vorrichtung vor, umfassend einen Schachtofen zum Einschmelzen von Schrott mit einer Austragsöffnung zum Austragen der erzeugten Stahlschmelze und der anfallenden Schlacke und einen mit der Austragsöffnung in Verbindung stehenden Durchlaufofen zum Überhitzen und Raffinieren der Schmelze, wobei der Durchlaufofen an einem Ende eine Eintragsöffnung zum Eintragen der aus dem Schachtofen ausgetragenen Schmelze, eine an einem gegenüberliegenden Ende angeordnete erste Austragsöffnung zum Austragen von Stahlschmelze, eine von der ersten Austragsöffnung gesonderte zweite Austragsöffnung zum Ausbringen von Schlacke und einen Ofengasabzug aufweist, wobei der Abzug des Durchlaufofens mit einer Entstaubungsvorrichtung und mit einem Abhitzekessel um das Abgas durch den Abhitzekessel zu leiten verbunden ist, wobei das Ofengas einem Brenner des Schachtofens zugeführt ist.

Wesentlich ist somit, dass der Einschmelzprozess zweistufig gestaltet ist, wobei die erste Stufe im Schachtofen und die zweite Stufe im Durchlaufofen erfolgt, wobei beide Stufen jeweils kontinuierlich arbeiten. Durch die zweistufige Arbeitsweise wird es möglich, die Ofengase aus dem Durchlaufofen energetisch zu nutzen und insbesondere die enthaltene Energie dem Einschmelzprozess rückzuführen. Die Erfindung eignet sich insbesondere für die Erzeugung einer flüssigen Stahlschmelze aus organisch oder anorganisch kontaminiertem Schrott.

Der Schachtofen dient als Schrottschmelzreaktor, in den Schrott, Kohlenstoffträger, wie z.B. Koks, und Zuschlagsstoffe, wie z.B. Kalk, bevorzugt über Eintragsschleusen und ein Tauchrohr eingebracht werden. Die für das Aufschmelzen des eingesetzten Schrotts erforderliche Prozesswärme wird im unteren Bereich des Schachtofens durch Zufuhr von Regelbrennstoffen (wie z.B. Erdgas und Heizöl) und ggf. gereinigtem Ofengas und Sauerstoff zum Brenner sichergestellt. Die im Bereich des Schmelzraumes abgestützte Schrottsäule mit eingemischtem Koks und Zuschlagsstoffen wird über die Brenner von unten aufgeschmolzen und sinkt im Ausmaß der Aufschmelzung ab, wobei die Schmelze und die sich bildende Schlacke mit nicht oxidiertem Koks abfließen und über einen bodenseitigen Abstich abgezogen werden. Durch den Zusatz von Kohlenstoffträgern ergibt sich eine Einschränkung der Oxidation von Eisen. Beim Anfahren der Einschmelzanlage wird der Schachtofen in der Regel nur mit Regelbrennstoffen befeuert, da die Gasqualität des Ofengases aus dem Durchlaufofen noch nicht ausreicht, um als Brennstoff eingesetzt zu werden. In der Phase des stabilen Betriebs hingegen kann das ggf. gereinigte und/oder entstaubte Ofengas dem Brennstoff zugemischt werden, um auf diese Art und Weise den Verbrauch des Regelbrennstoffes zu verringern. Die Qualität des Ofengases ist insbesondere dann für die Verwendung als Brennstoff ausreichend, wenn es ausreichende Mengen an CO, H₂ und CₓH_{y} enthält.

Die Badtemperatur wird im Schachtofen bevorzugt auf Werte von 1.520 bis 1.540°C gehalten, sodass der Schrott, der in der Regel einen Schmelzpunkt von ca. 1.510°C aufweist, nur leicht überhitzt wird. Die Verbrennung erfolgt im Schachtofen bevorzugt unterstöchiometrisch, wodurch eine reduzierende Ofenatmosphäre eingestellt werden kann. Mittels Ofendruckregelung wird bevorzugt ein leichter Unterdruck im Schachtofen erzeugt. Der Unterdruck beträgt bevorzugt -5 bis -15 Pa.

Durch die optionale Zufuhr von Reaktionsluft in den mittleren Teil des Schachtofens kann eine teilweise Oxidation des Ofengases erreicht werden, um die Wärme, die in den organischen Bestandteilen des Schrotts chemisch gebunden ist, nutzen zu können. Das anfallende Abgas enthält in der Regel CO, H₂, H₂O, CO₂ und CₓH_{y} und wird im oberen Teil des Schachtofens ausgetragen und bevorzugt einer Nachbrennkammer zugeführt. Die erzeugte Stahlschmelze und auch die anfallende Schlacke werden über den sich im unteren Teil des Schachtofens befindlichen Austrag dem Durchlaufofen zugeführt.

Der Durchlaufofen ist bevorzugt als Elektrolichtbogen-Durchlaufofen ausgebildet und dient der Überhitzung (bevorzugt auf ca. 1.650 - 1.700°C) und Raffination der vom Schachtofen kommenden Schmelze. Er ist als kontinuierlich laufender Elektrolichtbogenofen ausgeführt. Zur Erzielung einer niedrigeren Badströmungsgeschwindigkeit und folglich einer längeren Verweilzeit (bevorzugt mindestens 30 Minuten) im Überhitzungsbereich unter den Elektroden ist die Ofenwanne länglich ausgebildet, d.h. die Ofenwanne weist in Durchlaufrichtung eine größere Erstreckung auf als quer dazu. Insbesondere ist die Ofenwanne in Form einer Ellipse ausgebildet. Die längere Verweilzeit ist erforderlich, um das Raffinieren der Schmelze zu ermöglichen. Der Rohstahl wird an dem dem Zulauf gegenüberliegenden Ende des Durchlaufofens bevorzugt über ein Siphonsystem kontinuierlich in eine Pfanne abgegossen. Der Schlackenabfluss erfolgt ebenfalls kontinuierlich auf der Zulaufseite. Über einen Sauerstoffbrenner können bei Bedarf Zusatzbrennstoffe, Blaskoks und Sauerstoff in das Ofengefäß eingebracht werden. Ein leichter Unterdruck zur Begrenzung des Falschlufteintrages kann bevorzugt über eine Ofendruckregelung sichergestellt werden. Das Ofengas kann bevorzugt über ein Deckelloch ausgetragen werden.

Die Erfindung sieht bevorzugt vor, dass das aus dem Durchlaufofen abgezogene Ofengas und/oder das aus dem Schachtofen abgezogene Abgas einer Entstaubung unterzogen und der abgeschiedene Staub in einem Staubschmelzreaktor aufgeschmolzen wird. Die Staubabscheidung erfolgt dabei bevorzugt in einem Grobstaubabscheider und ggf. zusätzlich in einem Elektrofilter.

Der Staubschmelzreaktor dient zur weitestgehenden Wiederverwertung von im Prozess abgeschiedenen Stäuben. Er ist bevorzugt als Flashmelter ausgeführt und oberhalb des Durchlaufofens angeordnet. Bevorzugt werden die Stäube in einem Zyklonbrenner des Staubschmelzreaktors mit Brennstoff, z.B. Erdgas, und Sauerstoff und bei Bedarf mit Additiven (z.B. Kalk) aufgeschmolzen. Danach kann die Schmelze dem Durchlaufofen zugeführt werden. Das Abgas aus dem Staubschmelzrektor kann zur Abscheidung von Schwermetallresublimaten gequencht und in einem Schlauchfilter entstaubt werden. Optional kann vor dem Schlauchfilter eine Chemisorption eingeführt werden. Das gereinigte Abgas wird bevorzugt über ein zentrales Abgassystem ausgetragen.

Gemäß einer bevorzugten Ausbildung der Erfindung ist vorgesehen, dass das aus dem Schachtofen abgezogene, bevorzugt nachverbrannte Abgas zur energetischen Nutzung seiner fühlbaren Wärme durch einen Abhitzekessel geleitet wird. Als Abhitzekessel (auch Abhitzedampferzeuger) wird hierbei bevorzugt ein Dampfkessel verstanden, der das heiße Ofengas bzw. Abgas zur Dampferzeugung nutzt. Auf diese Weise wird die Abwärme des Prozesses, die sonst ungenutzt in die Atmosphäre verloren ginge, zurückgewonnen und der energetische Wirkungsgrad der Anlage verbessert sich. Der erzeugte Dampf kann beispielsweise in einer Fernwärmeanlage genutzt oder mittels einer Dampfturbine verstromt werden. Alternativ kann der Abhitzekessel mit Thermoöl betrieben und die gewonnene Abwärme in einem ORC (Organic Rankine Cycle) zur Verstromung genutzt werden.

Das im Abhitzekessel abgekühlte, ggf. nachverbrannte Abgas aus dem Schachtofen kann zur Abscheidung von SOx, HCl/HF, PCDD/F sowie hochflüchtigen anorganischen Verbindungen bevorzugt einer Chemisorption unterzogen werden. Die Chemisorption umfasst dabei bevorzugt das Eindüsen von Quenchwasser, Kalkhydrat (Ca(OH)₂) und Herdofenkoks in den Abgasstrom. Anschließend kann eine Entstaubung des Abgases in einem Schlauchfilter erfolgen. Bevorzugt werden die abgeschiedenen Stäube zumindest teilweise zwecks Wiederverwertung dem Staubschmelzrektor zugeführt. Um Kreisläufe von flüchtigen anorganischen Bestandteilen aufzubrechen, wird ein Teil des abgeschiedenen Staubes bevorzugt ausgeschleust. Das gereinigte Abgas kann über einen durch eine Ofendruckregelung geregelten Ventilator durch einen Abgaskamin ausgetragen werden.

Das bevorzugt grobentstaubte und im Abhitzekessel auf ca. 200 bis 300°C abgekühlte Ofengas aus dem Durchlaufofen kann mit einem Elektrofilter feinentstaubt werden. Die abgeschiedenen Stäube werden bevorzugt zumindest teilweise zwecks Wiederverwertung dem Staubschmelzrektor zugeführt. Um Kreisläufe von flüchtigen Bestandteilen aufzubrechen, kann ein Teil des augeschiedenen Staubes ausgeschleust werden.

Bevorzugt wird die Erfindung so durchgeführt, dass das vom Schachtofen kommende Abgas in der bereits oben erwähnten Nachbrennkammer mittels thermischer Nachverbrennung von CO und organischen Komponenten gereinigt wird. Während der Hochfahrphase der Einschmelzanlage kann in der Nachbrennkammer auch das noch einen zu niedrigen Heizwert aufweisende Ofengas aus dem Durchlaufofen verbrannt werden. Die Zufuhr der erforderlichen Reaktionsluft in die Nachbrennkammer erfolgt bevorzugt über eine Regelklappe, deren Steuerung über eine Abgasanalyse erfolgt. Die Abgasanalyse umfasst die Messung des O₂-, CO-, SO₂- und/oder HCl-Gehalts, sodass die Menge der je Zeiteinheit zugeführten Reaktionsluft sowie des Absorbens und Adsorbens zur Chemisorption eine Funktion der entsprechenden Messwerte ist.

Die Erfindung wird nachfolgend anhand eines in der Zeichnung schematisch dargestellten Ausführungsbeispiels näher erläutert. In dieser zeigen Fig. 1 den schematischen Aufbau der Einschmelzanlage, Fig. 2 eine Detaildarstellung der Ofenwanne des Durchlaufofens in einer Draufsicht und Fig. 3 die Ofenwanne im Querschnitt.

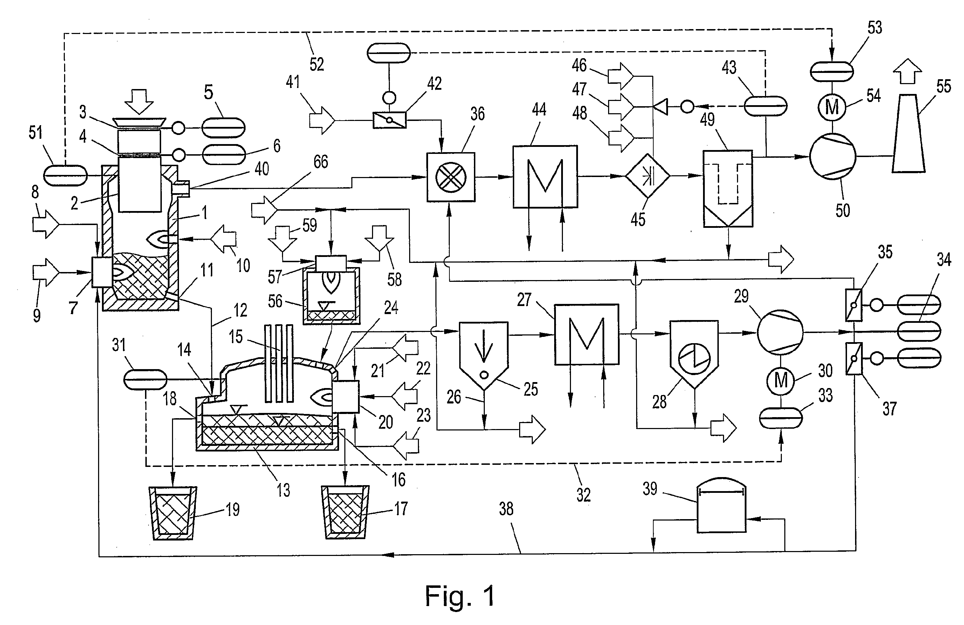

In Fig. 1 ist ein Schachtofen mit 1 bezeichnet, welchem über ein Tauchrohr 2 Schrott, Koks und Kalk aufgegeben werden. Im Eintragsbereich sind die Eintragsschleusen 3 und 4 vorgesehen, wobei mittels einer jeweils zugeordneten freiprogrammierbaren Steuervorrichtung 5 bzw. 6 eine Zeitsteuerung zur Verfügung gestellt wird, sodass die Eintragsschleusen 3 und 4 beispielsweise in vorgegebenen Zeitintervallen geöffnet und danach wieder geschlossen werden. Auf diese Art und Weise kann das Einsatzmaterial batchweise in den Schachtofen 1 eingebracht werden. Im unteren Bereich des Schachtofens 1 ist ein Brenner 7 angedeutet, der mit einem Brennstoff wie beispielsweise Erdgas 8 und Sauerstoff 9 betrieben wird. Der Schachtofen 1 wird mit einer leicht reduzierenden Ofenatmosphäre betrieben, sodass durch Zufuhr von Reaktionsluft 10 im mittleren Bereich des Schachtofens 1 eine teilweise Oxidation des Ofengases erzielt werden kann.

Das die erzeugte Stahlschmelze und die anfallende Schlacke umfassende schmelzflüssige Material wird über eine Austragsöffnung 11 aus dem Schachtofen 1 ausgetragen und über eine schematisch dargestellte Verbindung 12 und eine Eintragsöffnung 14 dem Durchlaufofen 13 aufgegeben. Der Durchlaufofen 13 ist als Elektrolichtbogenofen ausgebildet, dessen Elektroden mit 15 bezeichnet sind. An dem der Eintragsöffnung 14 gegenüberliegenden Ende des Durchlaufofens 13 wird die Stahlschmelze über eine erste Austragsöffnung 16, welche als Siphon ausgebildet ist, ausgetragen und in ein Gefäß 17 verbracht. Über eine eintragsseitig angeordnete zweite Austragsöffnung 18 wird die Schlacke in ein Gefäß 19 ausgetragen. Ein bevorzugt als Kohärenzbrenner ausgebildeter Sauerstoffbrenner 20 dient dazu, Zusatzbrennstoffe 21, Blaskoks 22 und Sauerstoff 23 in den Durchlaufofen 13 einzubringen. Dadurch kann gezielt Schaumschlacke produziert werden, wobei es mittels des eingebrachten Kohlenstoffs zu einer direkten Reduktion von FeO zu Fe unter der Ausbildung von CO kommt. Die im Durchlaufofen 13 erzeugte Schaumschlacke dient einerseits der Isolation und andererseits, aufgrund der Oberflächenvergrößerung, der Verbesserung der Reaktionsbedingungen, sodass der Schwefelgehalt verringert wird und Schwermetalle abdampfen können.

Das im Durchlaufofen 13 entstehende Ofengas wird über einen Ofengasabzug 24 abgezogen. Das Ofengas besteht hierbei hauptsächlich aus CO und H₂. Das Ofengas wird zunächst in einem Grobabscheider 25 grob entstaubt, wobei der abgeschiedene Staub mit 26 bezeichnet ist. Das grobentstaubte Ofengas wird danach durch einen Abhitzekessel 27 geleitet, in dem die fühlbare Wärme des Ofengases zur Dampferzeugung genutzt wird. Das grobentstaubte und im Abhitzekessel 27 auf eine Temperatur von beispielsweise 200°C bis 300°C abgekühlte Ofengas wird anschließend in einem Elektrofilter 28 feinentstaubt. Danach wird das Ofengas durch ein Gebläse 29 gesaugt, wobei der Antrieb 30 des Gebläses 29 in Abhängigkeit von dem im Durchlaufofen 13 herrschenden Druck geregelt wird. Ein entsprechender Ofendrucksensor ist mit 31 bezeichnet und ist über eine Steuerleitung 32 mit einer Steuervorrichtung 33 verbunden, um die Saugleistung des Gebläses 29 im Hinblick auf die Einhaltung eines vorgegebenen Unterdrucks im Durchlaufofen 13 einzustellen.

Das Ofengas wird danach einer schematisch mit 34 angedeuteten Gasanalyse unterzogen, wobei der Gehalt von O₂, CO, H₂, H₂O und CₓH_{y} festgestellt wird. In der Hochfahrphase des Einschmelzprozesses enthält das Ofengas in der Regel einen relativ hohen O₂-Gehalt und einen relativ niedrigen Gehalt an reduzierenden Bestandteilen, wie z.B. CO, H₂ und CₓH_{y}, sodass das Ofengas durch Ansteuerung einer Klappe 35 einer Nachbrennkammer 36 zugeführt wird. Sobald die Gasanalyse 34 einen ausreichenden Anteil von reduzierenden Bestandteilen, wie insbesondere CO, H₂ und CₓH_{y} feststellt, kann das Ofengas durch Öffnen der Klappe 37 über die Rückführungsleitung 38 dem Brenner 7 des Schachtofens 1 als Brennstoff zugeführt werden. Optional kann die Rückführungsleitung 38 mit einem Gasspeichergefäß 39 ausgestattet sein, welches eine Zwischenspeicherung von Ofengas für eine spätere Verwendung als Brenngas im Brenner 7 dient. Das über die Rückführungsleitung 38 dem Brenner 7 zugeführte Ofengas kann eine Temperatur von 200°C bis 300°C aufweisen, wobei die fühlbare Wärme des Ofengases für den Betrieb des Schachtofens 1 genutzt werden kann.

Das Abgas des Schachtofens 1 wird über einen Abzug 40 ausgetragen und der Nachbrennkammer 36 zugeführt, in der eine thermische Nachverbrennung zur Reinigung des Abgases von CO und organischen Komponenten durchgeführt wird. Das Ofenabgas des Schachtofens 1 enthält in der Regel CO, H₂, H₂O, CO₂ und CₓH_{y}. Der Nachbrennkammer 36 wird Reaktionsluft 41 zugeführt, die über eine Regelklappe 42 gesteuert wird, wobei die Steuerung in Abhängigkeit von Werten einer Abgasanalyse 43 vorgenommen wird. In der Abgasanalyse 43 wird der Gehalt an O₂, CO, SO₂ und HCl ermittelt, wobei beispielsweise so vorgegangen werden kann, dass das Abgas auf einen O₂-Gehalt von 8 Vol.-% geregelt wird. Das aus der Nachbrennkammer 36 austretende Abgas wird durch einen Abhitzekessel 44 geführt, der so wie der Abhitzekessel 27 zur Dampferzeugung genutzt wird. Danach wird das Abgas einer Chemisorption 45 unterzogen. Dabei werden zur Abscheidung von SOx, HCl/HF, PCDD/F sowie hochflüchtigen anorganischen Verbindungen Quenchwasser 46, Kalkhydrat 47 und Herdofenkoks 48 in den Abgasstrom eingedüst, wobei anschließend eine Entstaubung in einem Schlauchfilter 49 erfolgt. Im Staubfilter 49 werden unter anderem resublimierte Schwermetalle abgeschieden.

Das Ofengebläse 50 dient wiederum dazu, einen definierten Unterdruck im Schachtofen 1 einzustellen, wobei ein Drucksensor 51 Druckwerte liefert, die über eine Steuerleitung 52 der Steuervorrichtung 53 zugeführt werden, welche den Motor 54 des Gebläses 50 zur Einstellung der jeweils erforderlichen Saugleistung ansteuert. Das gereinigte Abgas wird schließlich durch einen Abgaskamin 55 ausgetragen.

Der an den verschiedenen Stellen ausgetragene Staub, d.h. beispielsweise der im Grobstaubabscheider 25, im Elektrofilter 28 oder im Schlauchfilter 49 abgeschiedene Staub, wird einem Staubschmelzreaktor 56 aufgegeben. In einem Zyklonbrenner 57 werden die Stäube mit Brennstoff wie z.B. Erdgas 58 und Sauerstoff 59 und ggf. die Schlackenbildung fördernden Additiven 66, wie z.B. Kalk, unter reduzierenden Bedingungen aufgeschmolzen, wobei der Staubschmelzreaktor 56 beispielsweise als Flashmelter ausgeführt sein kann. Die im Staubschmelzreaktor 56 erzeugte Schmelze wird dem Durchlaufofen 13 zugeführt.

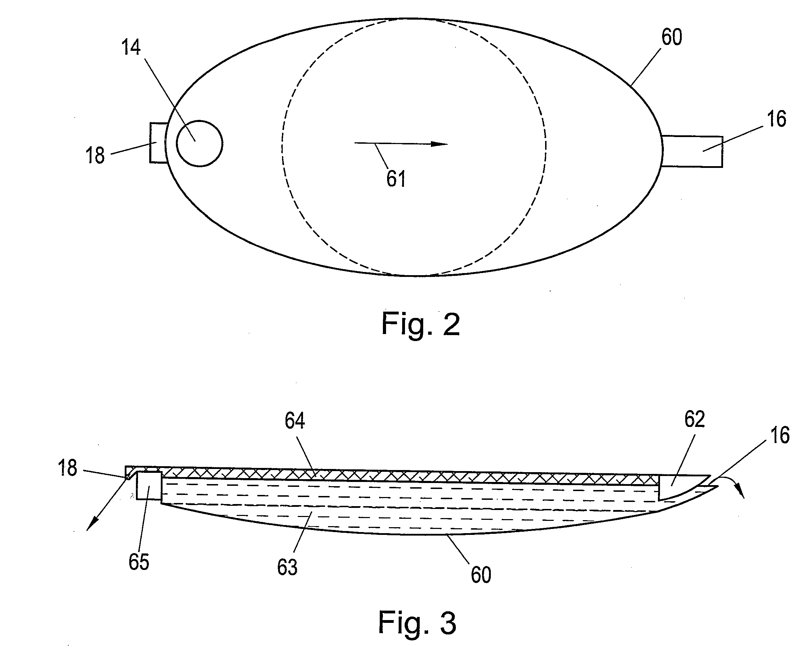

In Fig. 2 ist eine Draufsicht des Durchlaufofens 13 dargestellt. Der Durchlaufofen 13 weist eine elliptische Ofenwanne 60 auf, sodass sich in Durchlaufrichtung 61 eine wesentlich höhere Erstreckung ergibt als in einer Richtung quer dazu.

In der Querschnittsansicht gemäß Fig. 3 ist weiters ersichtlich, dass die Ofenwanne 60 im mittleren Bereich eine größere Tiefe aufweist als in den Randbereichen. Im mittleren Bereich kann somit mehr Material aufgenommen werden, sodass sich eine weitere Verringerung der Badströmungsgeschwindigkeit in Richtung des Pfeils 61 ergibt und es folglich zu einer längeren Verweilzeit der Schmelze im Durchlaufofen 13 kommt, wodurch die Raffination der Schmelze begünstigt wird. In Fig. 3 ist weiters ersichtlich, dass die erste Austragsöffnung 16 durch einen Siphonstein 62 gebildet wird, sodass die auf der Stahlschmelze 63 aufschwimmende Schlacke 64 zurückgehalten wird. Die Schlacke 64 wird an der der ersten Austragsöffnung 16 gegenüberliegenden Seite angeordneten zweiten Austragsöffnung 18 ausgetragen, wobei ein Staustein 65 vorgesehen ist.

## Patentansprüche

1. Verfahren zur kontinuierlichen Erzeugung einer flüssigen Stahlschmelze aus Schrott, umfassend:
- kontinuierliches Einschmelzen von Schrott in einem Schachtofen (1),
- Austragen der erzeugten Stahlschmelze und der anfallenden Schlacke über eine im unteren Teil des Schachtofens (1) angeordnete Austragsöffnung (11),
- kontinuierliches Einbringen der ausgetragenen Stahlschmelze und der Schlacke in einen Durchlaufofen (13),
- kontinuierliches Überhitzen und Raffinieren der Schmelze im Durchlaufofen (13),
- voneinander gesondertes kontinuierliches Austragen der Stahlschmelze und der Schlacke aus dem Durchlaufofen (13),
- Abziehen von Ofengas aus dem Durchlaufofen (13),
- zumindest teilweise Entstaubung des Ofengases,
- Leitung des zumindest teilweise entstaubten Ofengases zur energetischen Nutzung seiner fühlbaren Wärme durch einen Abhitzekessel (27),
- Verwenden des Ofengases als Brenngas für einen Brenner (7) des Schachtofens (1).

2. Verfahren nach Anspruch 1, **dadurch gekennzeichnet, dass** als Durchlaufofen (13) ein Elektrolichtbogenofen verwendet wird, dessen Ofenwanne (60) in Durchlaufrichtung (61) eine größere Erstreckung aufweist als quer dazu.

3. Verfahren nach Anspruch 1 oder 2, **dadurch gekennzeichnet, dass** aus dem Schachtofen (1) abgezogenes Abgas einer thermischen Nachverbrennung zugeführt wird.

4. Verfahren nach Anspruch 1, 2 oder 3, **dadurch gekennzeichnet, dass** das aus dem Durchlaufofen (13) abgezogene Ofengas und/oder das aus dem Schachtofen (1) abgezogene Abgas einer Entstaubung unterzogen und der abgeschiedene Staub in einem Staubschmelzreaktor (56) aufgeschmolzen wird.

5. Verfahren nach einem der Ansprüche 1 bis 4, **dadurch gekennzeichnet, dass** der im Staubschmelzreaktor (56) aufgeschmolzene Staub dem Durchlaufofen (13) zugeführt wird.

6. Verfahren nach einem der Ansprüche 1 bis 5, **dadurch gekennzeichnet, dass** das aus dem Schachtofen (1) abgezogene Abgas zur energetischen Nutzung seiner fühlbaren Wärme durch einen Abhitzekessel (44) geleitet und der im Abhitzekessel (44) erzeugte Dampf bevorzugt in einer Fernwärmeanlage genutzt oder mittels einer Dampfturbine verstromt wird.

7. Verfahren nach einem der Ansprüche 1 bis 6, **dadurch gekennzeichnet, dass** im Schachtofen (1) und/oder im Durchlaufofen (13) ein Unterdruck erzeugt wird.

8. Vorrichtung zur kontinuierlichen Erzeugung einer flüssigen Stahlschmelze aus Schrott, insbesondere zur Durchführung des Verfahrens nach einem der Ansprüche 1 bis 7, umfassend einen Schachtofen (1) zum Einschmelzen von Schrott mit einer Austragsöffnung (11) zum Austragen der erzeugten Stahlschmelze und der anfallenden Schlacke und einen mit der Austragsöffnung (11) in Verbindung stehenden Durchlaufofen (13) zum Überhitzen und Raffinieren der Schmelze, wobei der Durchlaufofen (13) an einem Ende eine Eintragsöffnung (14) zum Eintragen der aus dem Schachtofen (1) ausgetragenen Schmelze, eine an einem gegenüberliegenden Ende angeordnete erste Austragsöffnung (16) zum Austragen von Stahlschmelze, eine von der ersten Austragsöffnung gesonderte zweite Austragsöffnung (18) zum Ausbringen von Schlacke und einen Ofengasabzug (24) aufweist, wobei der Abzug (24) des Durchlaufofens (13) mit einer Entstaubungsvorrichtung und mit einem Abhitzekessel (27) um das Abgas durch den Abhitzekessel (27) zu leiten verbunden ist, wobei das Ofengas einem Brenner (7) des Schachtofens (1) zugeführt ist.

9. Vorrichtung nach Anspruch 8, **dadurch gekennzeichnet, dass** der Durchlaufofen (13) ein Elektrolichtbogenofen ist, dessen Ofenwanne (60) in Durchlaufrichtung (61) zwischen der Eintragsöffnung (14) und der ersten Austragsöffnung (16) eine größere Erstreckung aufweist als quer dazu.

10. Vorrichtung nach Anspruch 8 oder 9, **dadurch gekennzeichnet, dass** aus dem Schachtofen (1) abgezogenes Abgas einer thermischen Nachverbrennung zugeführt ist.

11. Vorrichtung nach Anspruch 8, 9 oder 10, **dadurch gekennzeichnet, dass** der Abzug (24, 40) des Durchlaufofens (13) und/oder des Schachtofens (1) mit einer Entstaubungsvorrichtung verbunden ist, die mit einem Staubschmelzreaktor (56) zum Aufschmelzen des in der Entstaubungsvorrichtung abgeschiedenen Staubs verbunden ist.

12. Vorrichtung nach Anspruch 11, **dadurch gekennzeichnet, dass** der Staubschmelzreaktor (56) mit dem Durchlaufofen (13) verbunden ist, um aufgeschmolzenen Staub dem Durchlaufofen (13) zuzuführen.

13. Vorrichtung nach einem der Ansprüche 8 bis 12, **dadurch gekennzeichnet, dass** der Abzug (40) des Schachtofens (1) mit einem Abhitzekessel (44) verbunden ist, um das Abgas durch den Abhitzekessel (44) zu leiten.

14. Vorrichtung nach einem der Ansprüche 8 bis 13, **dadurch gekennzeichnet, dass** an den Schachtofen (1) und/oder den Durchlaufofen (13) ein Gebläse (29, 50) angeschlossen ist, um im Schachtofen (1) bzw. im Durchlaufofen (13) einen Unterdruck zu erzeugen.

## Claims

1. Method for continuously producing molten steel from scrap metal, comprising the steps of:
- continuously melting scrap metal in a shaft furnace (1)
- discharging the molten steel produced and the accumulated slag through a discharge opening (11) arranged in the lower part of the shaft furnace (1),
- continuously introducing the discharged molten steel and slag into a continuous furnace (13),
- continuously superheating and refining the molten steel in the continuous furnace (13),
- discharging the molten steel and the slag from the continuous furnace (13) continuously and separately from each other,
- drawing the furnace gas out of the continuous furnace (13),
- at least partially dedusting the furnace gas,
- passing the at least partially dedusted furnace gas through a waste heat recovery boiler (27) to enable the sensible heat thereof to be used for energy purposes,
- using the furnace gas as combustion gas for a burner (7) of the shaft furnace (1).

2. Method according to claim 1, **characterized in that** an electric arc furnace is used as the continuous furnace (13), the furnace tub (60) of which has a greater dimension in the flow-through direction (61) than transversely thereto.

3. Method according to claim 1 or 2, **characterized in that** exhaust gas drawn off from the shaft furnace (1) is fed to a thermal postcombustion.

4. Method according to claim 1, 2 or 3, **characterized in that** the furnace gas drawn off from the continuous furnace (13) and/or the furnace gas drawn off from the shaft furnace (1) undergoes a dedusting step, and the separated dust is melted in a dust melting reactor (56).

5. Method according to any one of claims 1 to 4, **characterized in that** the dust melted in the dust melting reactor (56) is returned to the continuous furnace (13).

6. Method according to any of claims 1 to 5, **characterized in that** the furnace gas drawn off from the shaft furnace (1) is passed through a waste heat recovery boiler (44) to enable the energy of the sensible heat in the furnace gas to be used, and the steam generated in the waste heat recovery boiler (44) is preferably used in a district heating plant or converted into electricity by a steam turbine.

7. Method according to any of claims 1 to 6, **characterized in that** a negative pressure is created in the shaft furnace (1) and/or in the continuous furnace (13).

8. Device for continuously producing molten steel from scrap metal, particularly for the purpose of carrying out the method according to any one of claims 1 to 7, comprising a shaft furnace (1) for melting scrap metal, having a discharge opening (11) for discharging the molten steel produced and the accumulated slag, and a continuous furnace (13) connected to the discharge opening (11) for superheating and refining the molten steel, wherein the continuous furnace (13) has an infeed opening (14) at one end for introducing the molten steel discharged from the shaft furnace (1), a first discharge opening (16) arranged at the opposite end thereof for discharging molten steel, a second discharge opening (18) arranged separately from the first discharge opening for discharging slag, and a furnace gas discharge flue (24), wherein the discharge flue (24) of the continuous furnace (13) is connected to a dedusting device and to a waste heat recovery boiler (27) so that the exhaust gas can be passed through the waste heat recovery boiler (27), wherein the furnace gas is fed to a burner (7) of the shaft furnace (1).

9. Device according to claim 8, **characterized in that** the continuous furnace (13) is an electric arc furnace, the furnace tub (60) of which has a greater dimension in the flow-through direction (61) between the infeed opening (14) and the first discharge opening (16) than transversely thereto.

10. Device according to claim 8 or 9, **characterized in that** exhaust gas drawn off from shaft furnace (1) is fed to a thermal postcombustion.

11. Device according to claim 8, 9 or 10, **characterized in that** the discharge flue (24, 40) of the continuous furnace (13) and/or of the shaft furnace (1) is connected to a dedusting device, which is connected to a dust melting reactor (56) for melting the dust that is separated in the dedusting device.

12. Device according to claim 11, **characterized in that** the dust melting reactor (56) is connected to the continuous furnace (13) to enable the melted dust to be fed to the continuous furnace (13).

13. Device according to any of claims 8 to 12, **characterized in that** the discharge flue (40) of the shaft furnace (1) is connected to a waste heat recovery boiler (44) so that is connected to a waste heat recovery boiler (44) so that the exhaust gas can be passed through the waste heat recovery boiler (44).

14. Device according to any of claims 8 to 13, **characterized in that** a fan (29, 50) is connected to the shaft furnace (1) and/or the continuous furnace (13) in order to create a negative pressure in the shaft furnace (1) and/or in the continuous furnace (13).

## Revendications

1. Procédé pour la fabrication en continu d'une masse fondue d'acier liquide à partir de ferraille, comportant les étapes consistant à :
- faire fondre en continu de la ferraille dans un four à cuve (1),
- décharger la masse d'acier fondue produite et les scories résultantes par une ouverture de décharge (11) agencée dans la partie inférieure du four à cuve (1),
- introduire en continu la masse d'acier fondue déchargée et les scories dans un four continu (13),
- surchauffer en continu et affiner la masse fondue dans le four continu (13),
- décharger en continu hors du four continu (13) la masse d'acier fondue et les scories séparément l'un de l'autre,
- extraire les gaz de four hors du four continu (13),
- dépoussiérer au moins partiellement les gaz de four,
- conduire les gaz de four au moins partiellement dépoussiérés à travers une chaudière de récupération de la chaleur perdue (27) pour l'exploitation énergétique de leur chaleur sensible,
- utiliser les gaz de four comme gaz de combustion pour un brûleur (7) du four à cuve (1).

2. Procédé selon la revendication 1, **caractérisé en ce qu'**un four à arc électrique est utilisé comme four continu (13), la cuve de four (60) ayant une étendue dans la direction de passage (61) plus grande que transversalement à celle-ci.

3. Procédé selon la revendication 1 ou 2, **caractérisé en ce que** les fumées extraites du four à cuve (1) sont transférées en vue d'une post-combustion thermique.

4. Procédé selon la revendication 1, 2 ou 3, **caractérisé en ce que** les gaz de four extraits du four continu (13) et/ou les fumées extraites du four à cuve (1) sont soumis à un dépoussiérage et les poussières séparées sont fondues dans un réacteur de fusion de poussières (56).

5. Procédé selon l'une des revendications 1 à 4, **caractérisé en ce que** les poussières fondues dans le réacteur de fusion de poussières (56) sont transférées vers le four continu (13).

6. Procédé selon l'une des revendications 1 à 5, **caractérisé en ce que** les fumées extraites du four à cuve (1) pour l'exploitation énergétique de leur chaleur sensible sont conduites à travers une chaudière de récupération de la chaleur perdue (44) et la vapeur produite dans la chaudière de récupération de la chaleur perdue (44) est de préférence utilisée dans une installation de chauffage urbain ou génère de l'électricité au moyen d'une turbine à vapeur.

7. Procédé selon l'une des revendications 1 à 6, **caractérisé en ce qu'**une dépression est créée dans le four à cuve (1) et/ou dans le four continu (13).

8. Dispositif pour produire en continu une masse fondue d'acier liquide à partir de ferraille, en particulier pour la mise en oeuvre du procédé selon l'une des revendications 1 à 7, comprenant un four à cuve (1) pour faire fondre des scories comportant une ouverture de décharge (11) pour décharger la masse d'acier fondue produite et la ferraille résultante, et un four continu (13) en communication avec l'ouverture de décharge (11) pour surchauffer et affiner la masse fondue, dans lequel le four continu (13) comporte, à une extrémité, une ouverture de chargement (14) pour charger la masse fondue déchargée du four à cuve (1), une première ouverture de décharge (16) agencée sur une extrémité opposée pour décharger la masse d'acier fondue, une seconde ouverture de décharge (18) séparée de la première ouverture de décharge pour retirer les scories, et une sortie de gaz de four (24), dans lequel la sortie (24) du four continu (13) est reliée à un dispositif de dépoussiérage et à une chaudière de récupération de la chaleur perdue (27) afin de conduire les fumées à travers la chaudière de récupération de la chaleur perdue (27), dans lequel les gaz de four sont transférés vers un brûleur (7) du four à cuve (1).

9. Dispositif selon la revendication 8, **caractérisé en ce que** le four continu (13) est un four à arc électrique dont la cuve de four (60) a une étendue dans la direction de passage (61) entre l'ouverture de chargement (14) et la première ouverture de décharge (16) plus grande que transversalement à celle-ci.

10. Dispositif selon la revendication 8 ou 9, **caractérisé en ce que** les fumées extraites du four à cuve (1) sont transférées en vue d'une post-combustion thermique.

11. Dispositif selon la revendication 8, 9 ou 10, **caractérisé en ce que** la sortie (24, 40) du four continu (13) et/ou du four à cuve (1) est reliée à un dispositif de dépoussiérage qui est lui-même relié à un réacteur de fusion de poussières (56) pour faire fondre les poussières séparées dans le dispositif de dépoussiérage.

12. Dispositif selon la revendication 11, **caractérisé en ce que** le réacteur de fusion de poussières (56) est relié au four continu (13) afin de transférer les poussières fondues vers le four continu (13).

13. Dispositif selon l'une des revendications 8 à 12, **caractérisé en ce que** la sortie (40) du four à cuve (1) est reliée à une chaudière de récupération de la chaleur perdue (44) afin de conduire les fumées à travers la chaudière de récupération de la chaleur perdue (44).

14. Dispositif selon l'une des revendications 8 à 13, **caractérisé en ce qu'**une soufflerie (29, 50) est adjacente au four à cuve (1) et/ou au four continu (13) afin de créer une dépression dans le four à cuve (1) ou dans le four continu (13).
